(19) Europäisches Patentamt
European Patent Office
Office européen des brevets

(11) **EP 2 471 179 B1**

(12) **EUROPEAN PATENT SPECIFICATION**

(45) Date of publication and mention
of the grant of the patent:
**04.03.2015 Bulletin 2015/10**

(21) Application number: **10761028.9**

(22) Date of filing: **07.10.2010**

(51) Int Cl.:
*H03J 1/00* *(2006.01)*

(86) International application number:
**PCT/EP2010/065038**

(87) International publication number:
**WO 2011/042512 (14.04.2011 Gazette 2011/15)**

(54) **CAPACITOR ARRAY AND METHOD FOR SWITCHING AN ALTERNATING CURRENT**

KONDENSATORANORDNUNG UND VERFAHREN ZUM UMSCHALTEN EINES WECHSELSTROMS

RÉSEAU DE CONDENSATEURS ET PROCÉDÉ DE COMMUTATION D'UN COURANT ALTERNATIF

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.10.2009 EP 09012821**

(43) Date of publication of application:
**04.07.2012 Bulletin 2012/27**

(73) Proprietor: **ams AG**
**8141 Unterpremstätten (AT)**

(72) Inventor: **LEONCAVALLO, Ruggero**
**A-8101 Gratkorn (AT)**

(74) Representative: **Epping - Hermann - Fischer Patentanwaltsgesellschaft mbH Schloßschmidstraße 5 80639 München (DE)**

(56) References cited:
**US-A1- 2005 012 565     US-A1- 2006 170 511**
**US-A1- 2007 247 237     US-A1- 2008 164 956**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a capacitor array and to a method for switching an alternating current.

A capacitor array comprises a capacitor arrangement and a further capacitor arrangement. The capacitor arrangement which comprises a capacitor and a switch is capable of building a high impedance or a low impedance for an alternating current depending on the state of operation of the switch. If the switch is open, the capacitor arrangement obtains a high impedance. If the switch is closed, the capacitor arrangement obtains a low impedance for an alternating current.

Document US 2007/0247237 A1 refers to a switched capacitor array which comprises a capacitor and a switch. A node between the capacitor and the switch is connected to a voltage source via a pull-up resistor and a pull-up transistor if the switch is open. The node is connected to a reference terminal via a switching transistor, if the switch is closed. Thus, an alternating current which flows through the capacitor flows at least partially to the reference terminal, if the switch is closed.

Document US 2005/0012565 A1 refers to an inductive capacitive filter. A capacitor bank comprises a capacitor, a transistor and a further capacitor which are coupled in series. The capacitor bank comprises a resistor, a further resistor and a switch arrangement that has a first and a second terminal for receiving a bias voltage and a ground potential. A first transistor of the switch arrangement couples the first terminal to an output of the switch arrangement. A second transistor of the switch arrangement couples the second terminal to the output of the switch arrangement. The output of the switch arrangement is coupled via the resistor to a node between the capacitor and the transistor and via the further resistor to a further node between the further capacitor and the transistor.

It is an object of the present invention to provide a capacitor array and a method for switching an alternating current wherein an alternating current can flow through a capacitor with reduced losses.

This object is solved by a capacitor array according to claim 1 and a method for switching an alternating current according to claim 12. Preferred embodiments are presented in the respective dependent claims.

In one embodiment, a capacitor array comprises a capacitor arrangement. The capacitor arrangement comprises a capacitor, a transistor, a resistor, a further capacitor, a further resistor and a switch arrangement. The capacitor and the transistor are coupled together in series via a node. The further capacitor is coupled in series to the transistor via a further node. The switch arrangement comprises a first and a second terminal as well as an output and a further output. The output of the switch arrangement is coupled to the node between the capacitor and the transistor via the resistor. The further output of the switch arrangement is coupled to the further node between the further capacitor and the transistor via the further resistor.

The first terminal of the switch arrangement receives a first voltage, whereas the second terminal of the switch arrangement receives a second voltage. The transistor has a first and a second state of operation. The first voltage is applied to the output and the further output of the switch arrangement during the first state of operation. The second voltage is applied to the output and the further output of the switch arrangement during the second state of operation.

The switch arrangement has a first switch which couples the first terminal of the switch arrangement to the output of the switch arrangement, a second switch which couples the second terminal of the switch arrangement to the output of the switch arrangement, a third switch which couples the first terminal of the switch arrangement to the further output of the switch arrangement and a fourth switch which couples the second terminal of the switch arrangement to the further output of the switch arrangement.

The capacitor array comprises at least one further capacitor arrangement and is a binary weighted capacitor array. The quality factors of the capacitor arrangement and of the at least one further capacitor arrangement are approximately equal.

Advantageously, the resistor is arranged between the node and the output of the switch arrangement. The node is coupled to the first and to the second terminal of the switch arrangement via the resistor. Thus, a short circuit of the node to the first or the second terminal is avoided. An energy loss is very low in both states of operation. An alternating current flows through the serial circuit of the capacitor and the transistor if the transistor obtains a low on-resistance.

The transistor can be a field-effect transistor, abbreviated FET. In one embodiment, the transistor is a junction field-effect transistor. In an alternative embodiment, the transistor is a metal-oxide-semiconductor field-effect transistor, abbreviated MOSFET. The transistor comprises a control terminal.

In one embodiment, a semiconductor body comprises the transistor. The transistor is implemented as a FET. The transistor comprises a source and a drain region of the first conductivity type. Moreover, the transistor comprises a further region of a second conductivity type. The second conductivity type is opposite to the first conductivity type. The source and the drain region are arranged in the further region in a distance. The further region can be realized as a substrate of the semiconductor body or a well of the semiconductor body. The control terminal of the transistor can be implemented as a gate electrode of the FET.

In an embodiment, the transistor obtains a low on-resistance in the first state of operation. Thus, the transistor is in a conducting state of operation. Accordingly, the transistor obtains a high resistance in the second state of operation. The second state of operation is a non-conducting state of operation of the transistor. The low and the high resistance respectively impedance can be measured between the source region and the drain region of the transistor.

In an embodiment, a direct current voltage, abbreviated DC voltage, at the node is set in the non-conducting state of operation of the transistor by the second voltage. The DC voltage can be set in the conducting state of the transistor by the first voltage. The alternating current flows through the capacitor and the transistor in the first state of operation and not to the first terminal.

In an embodiment, the pn-junction between the source region and the further region has a capacitance as well as the pn-junction between the drain region and the further region has a capacitance. A low value of the junction capacitance results in a high impedance of the junction capacitance.

In an embodiment, the second voltage is equal or lower than a supply voltage and equal or higher than a further supply voltage. The supply voltage has a positive value with respect to a reference potential terminal. The further supply voltage can have a negative value with respect to the reference potential terminal. Alternatively, the further supply voltage can be a reference potential provided at the reference potential terminal.

In an embodiment, the first conductivity type is p-doped and the second conductivity type is n-doped. Thus, the transistor is a p-channel MOSFET. The source region and the drain region are two p-doped regions in an n-doped further region. The further region is connected to the supply voltage. Advantageously, a low value of the junction capacitance is achieved in case of the second state of operation of the transistor. The first voltage can be equal or lower than the supply voltage. A threshold voltage of the FET depends on a voltage difference of the source terminal to the further region. Since the DC voltage at the node is provided by the first voltage in the first state of operation, a shift of the threshold voltage caused by a substrate effect is kept low or is at least constant. Thus, the on-resistance of the transistor in the first state of operation is reduced.

In an alternative embodiment, the first conductivity type is n-doped and the second conductivity type is p-doped. Thus, the transistor is an n-channel MOSFET. The source region and the drain region are two n-doped regions in a p-doped further region. The further region is connected to the further supply voltage. Thus, a low value of the junction capacitance is achieved in case of the second state of operation of the transistor. The first voltage can be equal or higher than the further supply voltage.

In an embodiment, a diode between the drain region and the further region and a diode between the source region and the further region are inversely biased if the transistor is in the second state of operation.

The semiconductor body can comprise the capacitor arrangement. Thus, the capacitor arrangement is arranged on a first area of the semiconductor body. A single semiconductor body can comprise the capacitor arrangement.

The capacitor array can be designed as a switchable capacitor array. The capacitor array comprises a set of capacitors that can be connected or disconnected by transistors.

In an embodiment, the capacitor array comprises parallel switchable capacitors. The capacitor arrangement and the at least one further capacitor arrangement are connected in parallel. The transistor of the capacitor arrangement and an at least one further transistor of the at least one further capacitor arrangement can be operated in the first and/or in the second state of operation respectively. Thus, the capacitance which is provided by the capacitor array can be controlled by controlling the transistor and the at least one further transistor. In case all transistors are in the second state of operation, that means are non-conducting, the effective capacitance of the capacitor array should be zero. But in practice, the effective capacitance of the capacitor array is determined by parasitic capacitances caused by the transistors in such a case.

In a further development, the quality factor of the capacitor array is constant and does not depend on the state of operation of the transistor of the capacitor arrangement and the at least one further transistor of the at least one further capacitor arrangement.

In an embodiment, the capacitance value of the first capacitor of the at least one further capacitor arrangement is twice the capacitance value of the capacitor of the capacitor arrangement. The transistor of the capacitor arrangement has a first width-to-length ratio W/L. The at least one further transistor of the at least one further capacitor arrangement has a second width-to-length ratio. The value of the second width-to-length ratio is twice of the value of the first width-to-length ratio. The capacitor arrangement and the at least one further capacitor arrangement are designed such that the width-to-length ratios of the transistors are adapted to the capacitance values of the capacitors. Thus, the quality factor of the capacitor arrangement and of the at least one further capacitor arrangement are equal.

The capacitor array can be used in systems where small switchable capacitors with high quality factors are required. For example, the capacitor array can be used in fine-tuning applications. The capacitor array can, for example, be comprised by a tunable filter, a tunable radio frequency input front end circuit and a tunable oscillator, such as a voltage controlled oscillator, a resistive-capacitive oscillator and a current controlled oscillator.

In an embodiment, an amplifier arrangement comprises the capacitor array and an amplifier circuit. The capacitor array is arranged between an output of the amplifier circuit and an input of the amplifier circuit. Thus, the gain of the amplifier arrangement and/or the frequency behavior of the gain of the amplifier arrangement can be controlled by control of the transistor and the at least one further transistor.

In an embodiment, an oscillator arrangement comprises the capacitor array. By controlling the capacitance of the capacitor array, the frequency of an output signal of the oscillator arrangement can be set.

In an embodiment, a method for switching an alternating current comprises to provide the alternating current to a series connection of a capacitor, a transistor and a further capacitor. The transistor is set in a first or a second state of operation depending on a control signal which is applied to a control terminal of the transistor. A first voltage is applied to an output of a switch arrangement during the first state of operation of the transistor and a second voltage is applied to the output of the switch arrangement during the second state of operation of the transistor. A resistor couples a node between the capacitor and the transistor to the output of the switch arrangement. A further output of the switch arrangement is coupled via a further resistor to a further node between the further capacitor and the transistor.

A first switch is arranged between a first terminal of the switch arrangement and the output. A second switch is arranged between a second terminal of the switch arrangement and the output. A third switch is arranged between the first terminal of the switch arrangement and the further output. A fourth switch is arranged between the second terminal of the switch arrangement and the further output.

A capacitor array comprises a capacitor arrangement which comprises the capacitor, the further capacitor, the transistor, the resistor, the further resistor and the switch arrangement. The capacitor array comprises at least one further capacitor arrangement and is a binary weighted capacitor array. The quality factor of the capacitor arrangement and of the at least one further capacitor arrangement are approximately equal.

In an embodiment, the capacitance value of a first capacitor of a second capacitor arrangement is twice the capacitance value of the capacitor of the capacitor arrangement. The transistor of the capacitor arrangement has a first width-to-length ratio. A further transistor of the second capacitor arrangement has a second width-to-length ratio which is twice of the value of the first width-to-length ratio. Thus, the quality factors of the capacitor arrangement and of the first capacitor arrangement are equal, at least if the transistor and the further transistor are both in the first state of operation. The transistors are conducting in the first state of operation.

In an embodiment, the capacitance value of a third capacitor of a third capacitor arrangement is four times the capacitance value of the capacitor of the capacitor arrangement. An additional transistor of the third capacitor arrangement has a third width-to-length ratio that is four times of the value of the first width-to-length ratio. Thus, the quality factors of the capacitor arrangement and of the third capacitor arrangement are equal.

It is an advantage of the method that the first and the second voltage are applied to the node via the resistor so that a DC voltage at the node can be controlled. Thus, the parasitic capacitance at the node can be reduced and can be kept constant. Since a short circuit of the node to the first or the second voltage is advantageously avoided, the energy loss is very low in both states of operation.

The following description of figures of exemplary embodiments may further illustrate and explain the invention. Devices with the same structure and the same effect, respectively, appear with equivalent reference symbols. In so far as circuits or devices correspond to one another in terms of their function in different figures, the description thereof is not repeated for each of the following figures.

Figures 1A to 1C      show an exemplary embodiment of a capacitor arrangement of the principle presented,

Figures 2A and 2B      show exemplary embodiments of capacitor arrangements and of a capacitor array of the principle presented,

Figures 3A and 3B      show alternative exemplary embodiments of capacitor arrangements and of a capacitor array of the principle presented,

Figure 4      shows exemplary simulation results,

Figure 5      shows an exemplary embodiment of an oscillator with a capacitor array of the principle presented,

Figures 6A and 6B      show exemplary embodiments of a capacitor and

Figures 7A to 7C      show exemplary embodiments of a resistor.

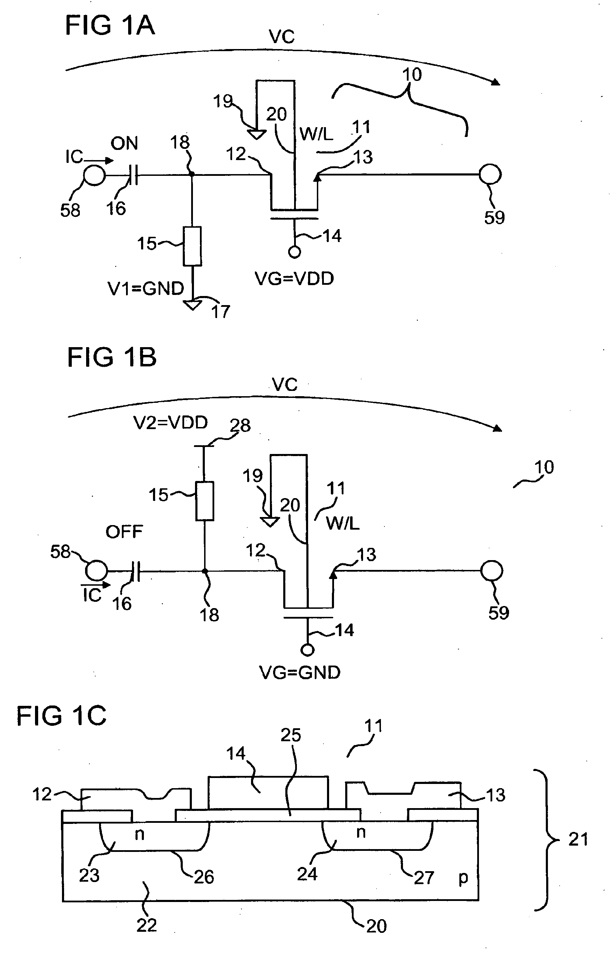

Figure 1A to 1C show an exemplary embodiment of a capacitor arrangement of the principle presented. A capacitor arrangement 10 comprises a transistor 11. The transistor 11 has a first and a second transistor terminal 12, 13 and a control terminal 14. The capacitor arrangement 10 comprises a resistor 15 and a capacitor 16. A controlled section of the transistor 11 and the capacitor 16 are connected in series. The first transistor terminal 12 is connected to an electrode of the capacitor 16 via a node 18. A further electrode of the capacitor 16 is connected to a first array terminal 58. The second transistor terminal 13 is coupled to a second array terminal 59. The transistor 11 is implemented as a FET. The transistor 11 is realized as an n-channel FET. The node 18 is coupled to a first terminal 17 via the resistor 15. The transistor 11 also comprises a substrate terminal 20. The substrate terminal 20 of the transistor 11 is connected to a reference potential terminal 19.

A control voltage VG is applied to the control terminal 14 of the transistor 11. The transistor 11 is in a first state of operation in Figure 1A. The first state is a conducting state of operation of the transistor 11. The control voltage VG has a high value so that the transistor 11 obtains a low on-resistance between the first and the second transistor terminal 12, 13. The control voltage VG has a value of a supply voltage VDD. The supply voltage VDD is a positive voltage in respect to a reference potential GND. The reference potential GND is provided at the reference potential terminal 19. The reference potential GND is applied to the substrate terminal 20 in Figures 1A and 1B. An alternating current IC flows through the capacitor arrangement 10. An alternating voltage VC is provided across the series circuit of the capacitor 16 and the transistor 11. A first voltage V1 is provided to the first terminal 17. The first voltage V1 has the value of the reference potential GND.

Figure 1B shows the same capacitor arrangement 10 as Figure 1A. However, the transistor 11 is set in a second state of operation. The second state is a non-conducting state of operation of the transistor 11. In the second state of operation, the first transistor terminal 12 is coupled via the node 18 and the resistor 15 to a second terminal 28. A second voltage V2 is provided at the second terminal 28. The second voltage V2 has the value of the supply voltage VDD. Therefore, the second voltage V2 is provided via the resistor 15 and the node 18 to the first transistor terminal 12. To set the transistor 11 in the second state of operation, the control voltage VG has the value of the reference potential GND. Thus, the transistor 11 shows a high impedance between the first and the second transistor terminal 12, 13. Figure 1C shows a cross-section of a semiconductor body 21 which comprises the transistor 11. The semiconductor body 21 comprises a first and a second region 23, 24 and a further region 22. The first region 23 is implemented as a source region. The second region 24 is implemented as a drain region. The first region 23 is contacted by the first transistor terminal 12. A first junction 26 is between the further region 22 and the first region 23. Accordingly, the second region 24 is contacted by the second transistor terminal 13. A second junction 27 is between the further region 22 and the second region 24. The further region 22 is connected to the substrate terminal 20. The control terminal 14 is implemented as a gate electrode. The control terminal 14 is capacitively coupled to the further region 22 via a gate isolator 25.

In case of Figure 1A, the transistor 11 is in the first state of operation and, therefore, conducting. The first voltage V1 has the value of the reference potential GND. Since the first voltage V1 is applied via the first node 18 and the first transistor terminal 12 to the first region 23 of the transistor 11 and the reference potential GND is also applied via the substrate terminal 20 to the further region 22, there is no voltage difference across the first junction 26. Thus, a diode between the further region 22 and the first region 23 does not conduct.

In case of Figure 1B, the transistor 11 is in the second state of operation and, therefore, non-conducting. The second voltage V2 is equal to the supply voltage VDD. Since the second voltage V2 is applied via the resistor 15, the node 18 and the first transistor terminal 12 to the first region 23 of the transistor 11 and the reference potential GND is applied via the substrate terminal 20 to the further region 22, the first junction 26 between the further region 22 and the first region 23 is reversed biased. A DC voltage at the node 18 is equal to the second voltage V2. Thus, the diode between the further region 22 and the first region 23 does not conduct and the space charge region between the first region 23 and the further region 22 is wide. A low capacitance value between the first transistor terminal 12 and the substrate terminal 20 is achieved. Consequently, the capacitance between the first transistor terminal 12 and the substrate terminal 20 results in a high impedance. Therefore, the overall impedance of the transistor 11 obtains a high value in the second state of operation. The alternating current IC is blocked.

An impedance Z of the capacitor arrangement 10 can be calculated according to the following equation:

$$Z = \frac{VC}{IC} = \frac{1}{j\,2\,\pi\,f\,CO} + RO,$$

wherein VC is a value of the alternating voltage, IC a value of the alternating current, j the imaginary unit, f the frequency of the alternating current, CO a capacitance value of the capacitor 16 and RO a resistance value of the controlled section of the transistor 11. The quality factor Q of the capacitor arrangement 10 can be calculated according to the following equation:

$$Q = \frac{1}{2\pi f \, RO \; CO}$$

By a decrease of the resistance RO, the quality factor Q increases. The decrease of the resistance RO can be achieved by increasing the dimensions of the transistor 11. By the increase of the dimensions of the transistor 11, the parasitic capacitance which is caused by the junction 26 increases also. In an embodiment, the parasitic capacitance of the transistor 11 is of the same order of magnitude as the capacitance value of the capacitor 16.

In an alternative, not shown embodiment, the transistor 11 is realized as a p-channel FET. Thus, the substrate terminal 20 is connected to a supply voltage terminal 29. In the first state of operation, the control voltage VG has the value of the reference potential GND and the first voltage V1 is equal to the supply voltage VDD. In the second state of operation, the control voltage VG has the value of the supply voltage VDD and the second voltage V2 is equal to the reference potential GND.

Alternatively, the reference potential GND can be replaced by a further supply voltage. The reference potential GND is positive in respect to the further supply voltage.

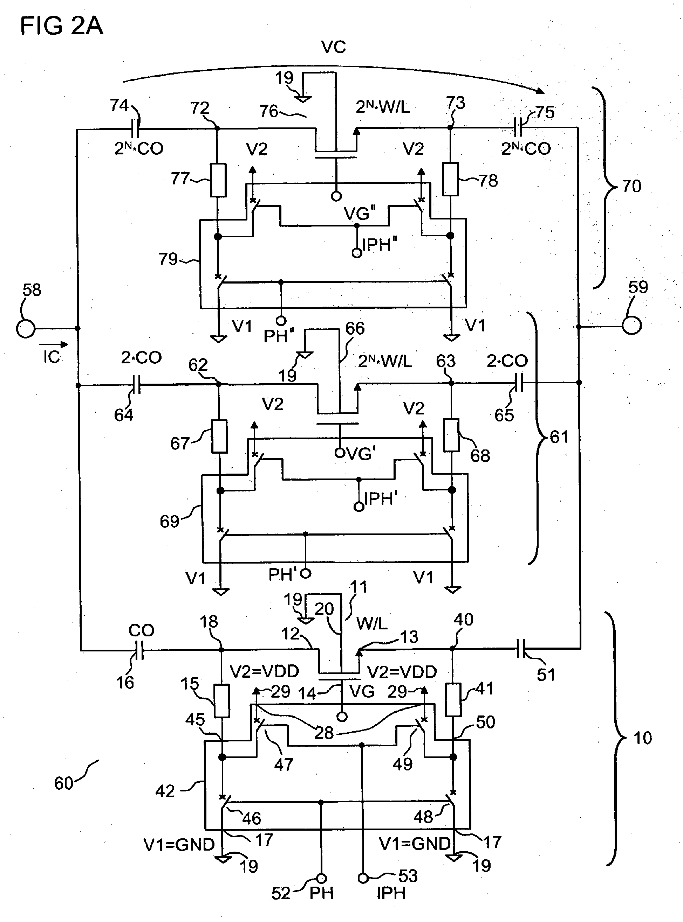

Figure 2A shows an exemplary embodiment of a capacitor array 60 comprising the capacitor arrangement 10. The capacitor arrangement 10 can be realized as shown in Fig. 1A to 1C. The capacitor arrangement 10 comprises the capacitor 16, the transistor 11, the resistor 15 and a switch arrangement 42. The switch arrangement 42 has the first terminal 17 and the second terminal 28. The first terminal 17 is connected to the reference potential terminal 19 and the second terminal 28 is connected to the supply voltage terminal 29. An output 45 of the switch arrangement 42 is coupled via the resistor 15 to the node 18. The switch arrangement 42 comprises a first and a second switch 46, 47. The first switch 46 is arranged between the first terminal 17 of the switch arrangement 42 and the output 45. The second switch 47 is arranged between the second terminal 28 of the switch arrangement 42 and the output 45. A control input 52 of the switch arrangement 42 is connected to a control terminal of the first switch 46. A further control input 53 of the switch arrangement 42 is connected to a control terminal of the second switch 47.

Moreover, the capacitor arrangement 10 comprises a further capacitor 51 and a further resistor 41. The capacitor 16, the transistor 11 and the further capacitor 51 are arranged in series. Thus, the capacitor 16, a controlled section of the transistor 11 and the further capacitor 51 are connected in series. The transistor 11 is arranged between the capacitor 16 and the further capacitor 51. The capacitance value of the capacitor 16 is approximately equal to a capacitance value of the further capacitor 51. A further node 40 is arranged between the further capacitor 51 and the transistor 11. The second transistor terminal 13 of the transistor 11 is connected via the further node 40 to an electrode of the further capacitor 51. A further electrode of the further capacitor 51 is connected to the second array terminal 59.

Moreover, the switch arrangement 42 comprises a third and a fourth switch 48, 49 and a further output 50. The further output 50 of the switch arrangement 42 is coupled via the further resistor 41 and the further node 40 to the second transistor terminal 13. The third switch 48 is arranged between the first terminal 17 of the switch arrangement 42 and the further output 50. The fourth switch 49 is arranged between the second terminal 28 of the switch arrangement 42 and the further output 50. The control input 52 is connected to a control terminal of the third switch 48. The further control input 53 is connected to a control terminal of the fourth switch 49.

The capacitor array 60 comprises the capacitor arrangement 10 and the first and the second array terminal 58, 59. The capacitor arrangement 10 is arranged between the first array terminal 58 and the second array terminal 59. Thus, the series circuit of the capacitor 16, the transistor 11 and the further capacitor 51 are arranged between the first array terminal 58 and the second array terminal 59. Moreover, the capacitor array 60 comprises a second capacitor arrangement 61. The second capacitor arrangement 61 is also arranged between the first array terminal 58 and the second array terminal 59. The second capacitor arrangement 61 has the same structure and equivalent components such as the capacitor arrangement 10. The second capacitor arrangement 61 comprises a first and a second capacitor 64, 65, a further transistor 66, a first and a second resistor 67, 68, a first and a second node 62, 63 and a further switch arrangement 69.

A capacitance value of the first capacitor 64 is equal to a capacitance value of the second capacitor 65. The capacitance values of the capacitor 16 and of the first capacitor 64 are different. The capacitance value of the first capacitor 64 is twice the capacitance value of the capacitor 16. The transistor 11 has a first width-to-length ratio W/L. The further transistor 66 has a second width-to-length ratio. The second width-to-length ratio is different from the first width-to-length ratio. The value of the second width-to-length ratio is twice of the value of the first width-to-length ratio.

The capacitor array 60 comprises a third capacitor arrangement 70 which has the same structure and equivalent devices such as the capacitor arrangement 10 and the first capacitor arrangement 61. The third capacitor arrangement 70 comprises a third and a fourth capacitor 74, 75, an additional transistor 76, a third and a fourth resistor 77, 78, a third and a fourth node 72, 73 as well as an additional switch arrangement 79.

The control signal VG is provided to the control terminal 14 of the transistor 11. A control signal PH is provided to the control terminal 52 of the switch arrangement 42 and, thus, to a control terminal of the first and the third switch 46, 48. Moreover, the further control signal IPH is provided to the further control input 53 and, thus, to a control terminal of the second and fourth switch 47, 49. The reference potential GND is provided to the first terminal 17 of the switch arrangement 42. The supply voltage VDD is provided to the second terminal 28 of the switch arrangement 42. In case the control signal PH has a logical value 1, the first switch 46 is closed and the first voltage V1 is applied via the output 45 of the switch arrangement 42 and the resistor 15 to the node 18. However, if the further control signal IPH has a logical value 1, the second switch 47 is closed and the second voltage V2 is provided via the output 45 of the switch arrangement 42 and the resistor 15 to the node 18. The control signal PH and the further control signal IPH are generated in such a way that only one of the two switches, namely the first switch 46 and the second switch 47, is closed at one point of time. The function of the third and the fourth switch 48, 49 depends on the control signal PH and the further control signal IPH in the same way as the function of the first and the second switch 46, 47.

The capacitor array 60 can comprise a first number N of capacitor arrangements 10, 61, 70 which are arranged in parallel between the first array terminal 58 and the second array terminal 59. The first number N is at least 1. The capacitance value CN of a capacitor in the N-th capacitor arrangement can be calculated according to the following equation:

$$CN = CO \cdot 2^N,$$

wherein CO is the capacitance value of the capacitor 16. The capacitor 16 is a unit capacitor. The capacitor array 60 is a binary weighted capacitor array. The last significant bit causes a capacitance change of the capacitor array 60 by the capacitance value CO. Accordingly, the width-to-length ratio WN/LN of the transistor in the N-th capacitor arrangement can be calculated according to the following equation:

$$\frac{WN}{LN} = \frac{WO}{LO} \cdot 2^N,$$

wherein WO/LO is the value of the first width-to-length ratio of the transistor 11. The resistance of the controlled section of the transistor is proportional to length-to-width ratio LN/WN. Therefore, the quality factors of the different capacitor arrangements 10, 61, 70 are approximately equal. Since the width-to-length ratio of the further transistor 66 is larger than the width-to-length ratio of the transistor 11, the area of the first region of the further transistor 66 has approximately twofold the value of the area of the first region 23 of the transistor 11. Consequently, the capacitance value of the junction between a first transistor terminal of the further transistor 66 and a substrate terminal of the further transistor 66 has a twofold value in comparison to the junction 26 between the first transistor terminal 12 and the substrate terminal 20 of the transistor 11. The physical limit of the capacitor array is met when the intrinsic capacitance of the transistor 11 obtains the same order of magnitude such as the capacitance CO of the capacitor 16.

The on-resistance of the transistor 11 can be decreased by increasing the dimension of the transistor 11. This can be achieved by an increase of the width-to-length ratio of the transistor 11. However, the increase of the dimension of the transistor 11 results in a larger parasitic capacitance in the second state of operation that means when the transistor 11 is non-conducting. By means of the switch arrangement 42, the resistor 15 and the further resistor 41 change the DC potentials at the first and the second transistor terminal 12, 13 of the transistor 11 according to the state of operation of the transistor 11 and thus reduce the parasitic effects of the transistor 11. The width of the space charge region obtains such a high value in case the transistors 11, 66, 76 are in the second state of operation that the stray capacitance between the first transistor terminal 12 and the substrate terminal 20 of the transistors 11, 66, 76 are so low that the capacitor 16 and the further capacitor 51 as well as the first, the second, the third and the fourth capacitor 64, 65, 74, 75 are switched off.

In an alternative embodiment, which is not shown, the capacitance value of the first capacitor 46 is not twice of the capacitance value of the capacitor 16. In an exemplary embodiment, the capacitance values of the capacitor 16, the further capacitor 51, the first and the second capacitor 64, 65 are equal.

In an alternative embodiment, which is not shown, the width-to-length ratio of the further transistor 66 has not the twofold value of the width-to-length ratio of the transistor 11.

In an alternative, not shown embodiment, at least one transistor of the transistor 11, the further transistor 66 and the additional transistor 76 are realized as p-channel. FETs.

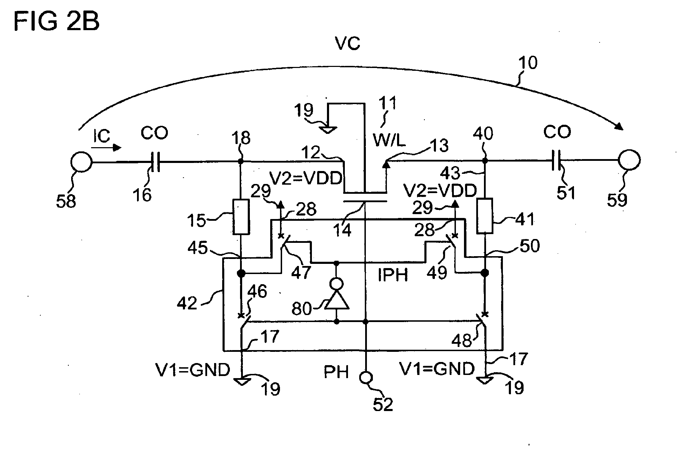

Figure 2B shows an exemplary embodiment of a capacitor arrangement 10' which can be inserted as a capacitor arrangement 10, 61, 70 in a capacitor array 60 shown in Figure 2A of the principle presented. The capacitor arrangement 10' of Figure 2B is a further development of the capacitor arrangements 10 of Figure 2A. In addition to the capacitor arrangement 10 shown in Figure 2A, the switch arrangement 42' shown in Figure 2B comprises an inverter 80. The control input 52 is connected to the control terminal 14 of the transistor 11. The control input 52 is coupled to the control terminal of the second switch 47 via the inverter 80. Additionally, the control input 52 is coupled to the control terminal of the fourth switch 49 via the inverter 80. Thus, the further control signal IPH is an inverted signal of the control signal PH. A short circuit between the first and the second terminal 17, 28 of the switch arrangement 42 is advantageously avoided.

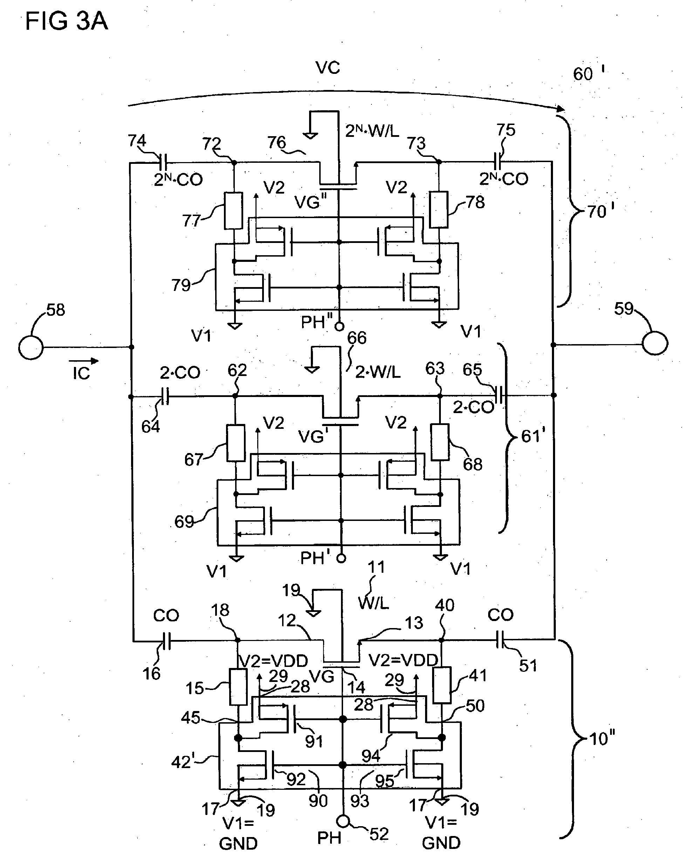

Figure 3A shows an exemplary embodiment of a capacitor array 60' comprising capacitor arrangements according to the principle presented. The capacitor array 60' according to Figure 3A is a further development of the capacitor array 60 and the capacitor arrangements 10, 10' shown in Figures 2A and 2B. According to Figure 3A, the switch arrangement 42' comprises a change-over switch 90. The change-over switch 90 is realized as an inverter. The change-over switch 90 comprises a first inverter transistor 91 and a second inverter transistor 92 which are connected in series. The change-over switch 90 is arranged between the first and the second terminal 17, 28. The control input 52 of the switch arrangement 42' is connected to a control terminal of the change-over switch 90 which is a control terminal of the inverter. Thus, the control input 52 is connected to a control terminal of the first inverter transistor 91 and to a control terminal of the second inverter transistor 92. A node between the first and the second inverter transistors 91, 92 is an output of the change-over switch 90. The output of the change-over switch 90 is connected to the output 45 of the switch arrangement 42'. The control input 52 is connected to the control terminal 14 of the transistor 11. The first inverter transistor 91 is realized as a p-channel FET and the second inverter transistor 92 as an n-channel FET.

Correspondingly, the switch arrangement 42' comprises a further change-over switch 93. The further change-over switch 93 is realized as an inverter. The further change-over switch 93 is arranged between the first terminal 17 and the second terminal 28. The further change-over switch 93 comprises a third inverter transistor 94 and a fourth inverter transistor 95. An input of the further change-over switch 93 is connected to the control input 52. A node between the third inverter transistor 94 and the fourth inverter transistor 95 is an output of the further change-over switch 93 and is connected to the further output 50 of the switch arrangement 42'. The capacitor arrangements 61', 70' have the same structure and devices such as the capacitor arrangement 10''. The control signal PH is provided to the change-over switch 90 and to the control terminal 14 of the transistor 11. If the control signal PH has a logical value 1, that means a high voltage value, the transistor 11 is in the first state of operation. The output of the change-over switch 90 has approximately the first voltage V1. The first voltage V1 is provided via the resistor 15 to the node 18. If the control signal PH has a logical value of 0, that means a low voltage level, the transistor 11 is switched in the second state of operation. The control signal PH effects that the output 45 has nearly the value of the second voltage V2. The second voltage V2 has the value of the supply voltage VDD. Thus, the node 18 and, therefore, the first transistor terminal 12 of the transistor 11 is nearly at the potential of the supply voltage VDD and the junction 26 between the first region 23 and the further region 22 is non-conducting. The junction 26 shows a large space charge region which results in a low capacitance value of the junction 26. Therefore, the capacitor arrangement 10'' has a high impedance value in case the control signal PH has a logical value 0. The function of the further change-over switch 93 corresponds to the function of the change-over switch 90. The structure and the function of the second capacitor arrangement 61' and of the third capacitor arrangement 70' correspond to the structure and the junction of the capacitor arrangement 10'.

The selection of the capacitance values of the different capacitors 16, 51, 64, 65, 74, 75 and the selection of the width-to-length ratio of the different transistors 11, 66, 76 of the capacitor array 60' in Figure 3A can be chosen correspondingly to the capacitance values and the width-to-length values in the capacitor array 60 of Figure 2A.

The capacitor arrays 60, 60' of Figure 2A and Figure 3A are realized as differential capacitor arrays. This means that the capacitor arrangement 10 comprises two capacitors 16, 51 and one transistor 11 in-between. In a not shown, alternative embodiment, the capacitor array 60, 60' is a single-ended capacitor array. In this case, the capacitor arrangement 10, 10', 10'' is a single-ended capacitor arrangement. The capacitor arrangement 10 comprises the capacitor 16, the transistor 11, the resistor 15 and the switch arrangement 42. The further capacitor 51 and the further resistor 41 are omitted. The second transistor terminal 13 of the transistor 11 is directly connected to the second array terminal 59 of the capacitor array 60. The second terminal 59 of the capacitor array 60 can be directly connected to a terminal having a constant DC voltage, for example the reference potential terminal 17 or the supply voltage terminal 29.

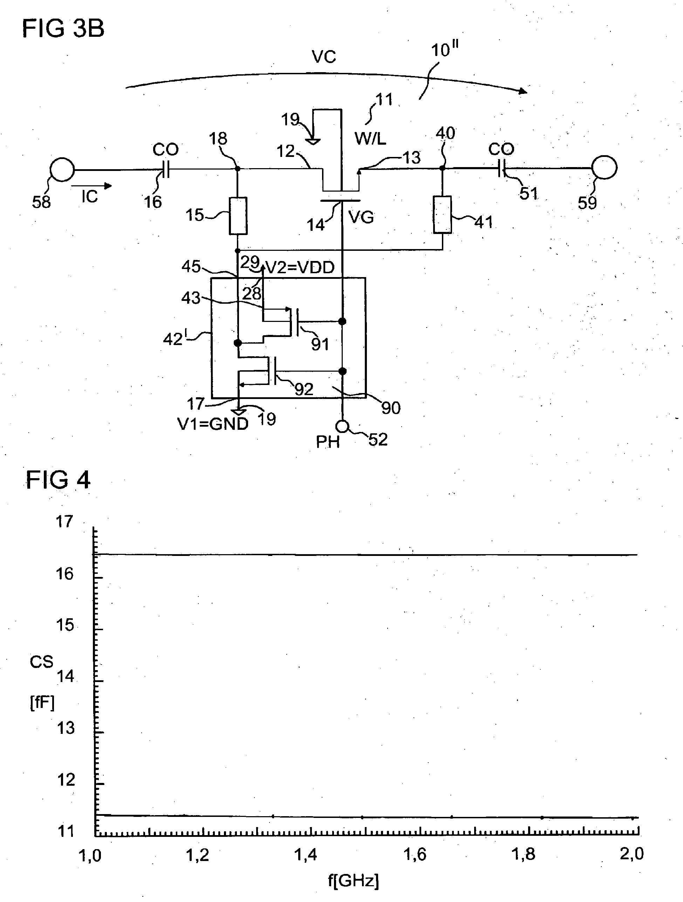

Figure 3B shows an exemplary embodiment of a capacitor arrangement 10'' which can be inserted in a capacitor array according to Figure 2A or 3A. The capacitor arrangement 10'' of Figure 3B is a further development of the capacitor arrangement 10', 10'' of Figures 2A and 3A. The switch arrangement 42' in Figure 3B does not comprise the further change-over switch 93. The switch arrangement 42' comprises the change-over switch 90 which couples the control input 52 to the output 45 of the switch arrangement 42'. The output 45 of the switch arrangement 42' is connected via the resistor 15 to the node 18 and via the further resistor 41 to the further node 40. The switch arrangement 42 provides by means of the change-over switch 90 the first or the second voltage V1, V2 via the output 45 and the resistor 15 to the node 18 and via the same output 45 and the further resistor 4-1 to the further node 40. The capacitor arrangement 10" of Figure 3B shows a small resistive path between the node 18 and the further node 40 which is caused by the series connection of the resistor 15 and further resistor 41.

It is an advantage of the switch arrangement 42' of Figure 3B that it comprises only two transistors. The semiconductor body 21 comprises the capacitor array 60. An area on the semiconductor body 21 can be small. This results in a very cost-effective way to produce such a capacitor array.

Figure 4 shows exemplary simulation results of a comparison of a capacitor arrangement according to the principle presented to a conventional capacitor arrangement. The upper line shows a residual capacitance CS of the conventional capacitor arrangement in dependency of the frequency of the alternating current IC in the second state of operation. The conventional capacitor arrangement only comprises a capacitor and a transistor, but does not comprise a resistor or a switch arrangement. The lower line shows the residual capacitance CS of a capacitor arrangement according to the principle presented in the second state of operation. The capacitor arrangement comprises the capacitor 16, the transistor 11, the resistor 15 and the switch arrangement 42. The residual capacitance CS is caused by parasitic elements in the capacitor arrangement 10. The residual capacitance CS is reduced by more than 30% by means of a capacitor arrangement of the principle presented in comparison to a conventional capacitor arrangement. The residual capacitance CS dropped from 16.3 femto Farad to 11.3 femto Farad. In a capacitor array with N bits, the improvement would be equal to $2^N$.

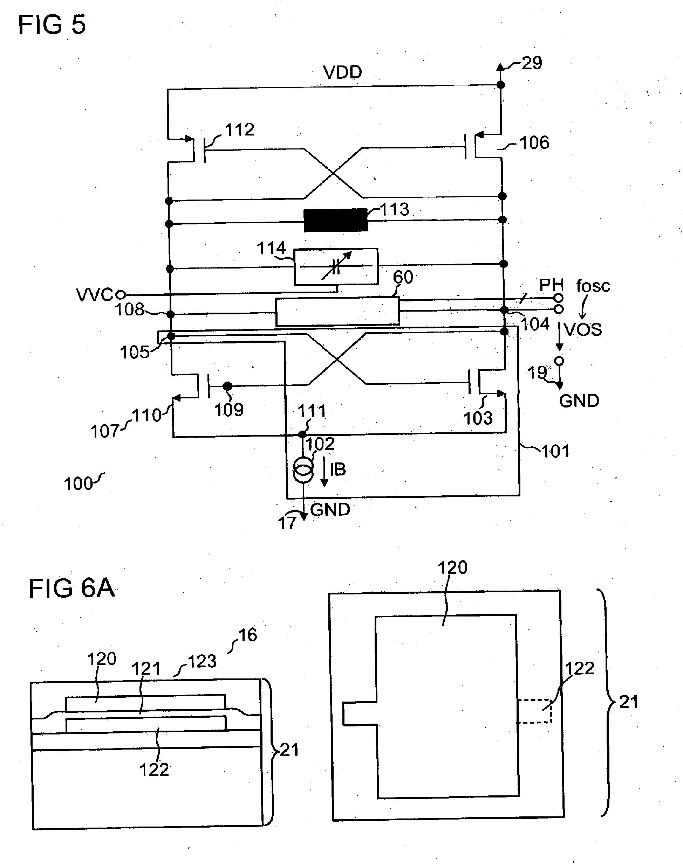

Figure 5 shows an exemplary embodiment of an oscillator arrangement with a capacitor array of the principle presented. The oscillator arrangement 100 comprises an amplifier circuit 101. The amplifier circuit 101 comprises a current source 102 and a first amplifier transistor 103 which are connected in series. The capacitor array 60 couples an output 104 of the amplifier circuit 101 to an input 105 of the amplifier circuit 101. The gain of the amplifier circuit 101 and/or the impedance characteristic of the gain can be controlled by the coupling via the capacitor array 60. The first amplifier transistor 103 is coupled via the output 104 of the amplifier circuit 101 and a second amplifier transistor 106 to the supply voltage terminal 29.

Furthermore, the oscillator arrangement 100 comprises a further amplifier circuit 107. An output 108 of the further amplifier circuit 107 is connected to the input 105 of the amplifier circuit 101. An input 109 of the further amplifier circuit 107 is connected to the output 104 of the amplifier circuit 101. The further amplifier circuit 107 comprises a third amplifier transistor 110. The first and the third amplifier transistors 103, 110 are cross-connected. A first transistor terminal of the third amplifier transistor 110 and a first transistor terminal of the first amplifier transistor 103 are connected to a current source node 111 which is coupled via the current source 102 to the reference potential terminal 17. The third amplifier transistor 110 is coupled via the output 108 of the further amplifier circuit 107 and a fourth amplifier transistor 112 to the supply voltage terminal 29. The second and the fourth amplifier transistors 106, 112 are cross-connected. A control terminal of the second amplifier transistor 106 is connected to the input 105 of the amplifier circuit 101. A control terminal of the fourth amplifier transistor 112 is connected to the output 104 of the amplifier circuit 101.

Moreover, a coil 113 is arranged between the output 104 and the input 105 of the amplifier circuit 101. Further on, a varactor 114 couples the output 104 to the input 105 of the amplifier circuit 101. The varactor 114 comprises a control terminal. The capacitor array 60 comprises the control input 52 and further control inputs. Thus, the capacitor array 60. is controlled via a bus line comprising the first number n of connection lines. The oscillator 100 comprises a first cross coupled pair of transistors comprising the first and the third amplifier transistor 103, 110. Moreover, the oscillator 100 comprises a second cross coupled pair of transistors comprising the second and the fourth amplifier transistors 106, 112. The first cross coupled pair of transistors 103, 110, the second cross coupled pair of transistors 106, 112 and the capacitor array 60 are arranged in parallel between an input 105 and an output 104. The capacitor array 60 provides a feedback path of the oscillator 100. The coil 113 and the varactor 114 can be connected parallel to the capacitor array 60 for providing the feedback path.

A varactor control signal WC-is provided to the control terminal of the varactor 114. The current source 102 provides a bias current IB. An oscillator output signal VOS is provided at the output 104. By the capacitor array 60 and by the varactor 114, an oscillating frequency fosc of the oscillator output signal VOS can be controlled.

Figure 6A shows an exemplary embodiment of a capacitor which can be inserted as one of the capacitors in the capacitor arrangement 10 of one of the previous figures. The capacitor 16 is realized as an integrated capacitor on the semiconductor body 21. The capacitor 16 comprises a first electrode 120, an isolating layer 121 and a second electrode 122. The capacitor 16 is implemented as an electrode/ isolating layer/electrode capacitor 123. The capacitor 16 is realized as a parallel plate capacitor. Figure 6A shows a cross-section and a top-view.

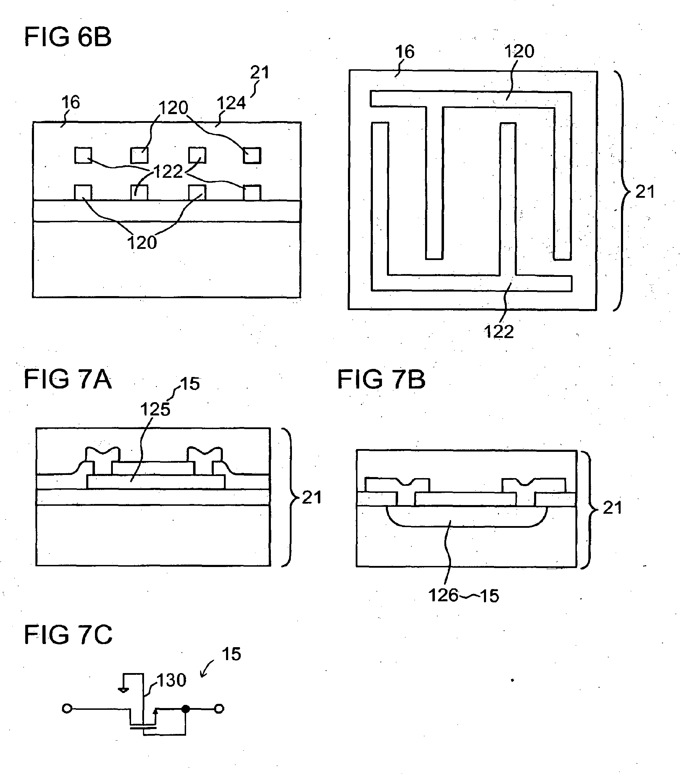

Figure 6B shows a further exemplary embodiment of a capacitor which can be used in the capacitor arrangements 10 shown above. Figure 6B shows a cross-section and a top-view. The capacitor 16' is implemented as a fringing capacitor 124. The capacitor 16' uses the stray capacitance between the first electrode 120 and the second electrode 122. The capacitor 16 can be implemented as an interdigitated capacitor. The first and the second electrodes 120, 122 are arranged in two metallization levels. Alternatively, the first and the second electrodes 120, 122 are arranged in one metallization level or in more than two metallization levels.

In one embodiment, the fringing capacitor 124 is implemented by metallization levels which are also used for conduction lines. Thus, no additional mask is necessary for the realization of the fringing capacitor 124.

Figure 7A shows an exemplary embodiment of a resistor which can be used in one of the capacitor arrangements 10 shown above. The resistor 15 is implemented as a thin-film resistor 125. The thin film resistor 125 can comprise a polysilicon film, a silicide film or a metal film. The metal film can comprise aluminium, copper, nickel, nickel-chromium, gold, tungsten or titanium.

Figure 7B shows another exemplary embodiment of a resistor which can be used in one of the capacitor arrangements 10 shown above. The resistor 15 is realized as a diffused resistor 126.

Figure 7C shows another exemplary embodiment of a resistor which can be used in one of the capacitor arrangements 10 shown above. The resistor 15 comprises a transistor 130. The transistor 130 is connected as a resistor.

Reference numerals

| | |
|---|---|
| 10, 10', 10" | capacitor arrangement |
| 11 | transistor |
| 12 | first transistor terminal |
| 13 | second transistor terminal |
| 14 | control terminal |
| 15 | resistor |
| 16, 16' | capacitor |
| 17 | first terminal |
| 18 | node |
| 19 | reference potential terminal |
| 20 | substrate terminal |
| 21 | semiconductor body |
| 22 | further region |
| 23 | first region |
| 24 | second region |
| 25 | gate isolator |
| 26 | first junction |
| 27 | second junction |
| 28 | second terminal |
| 29 | supply voltage terminal |
| 40 | further node |
| 41 | further resistor |
| 42, 42' | switch arrangement |
| 45 | output |
| 46 | first switch |
| 47 | second switch |
| 48 | third switch |
| 49 | fourth switch |
| 50 | further output |
| 51 | further capacitor |
| 52 | control input |
| 53 | further control input |
| 58 | first array terminal |
| 59 | second array terminal |
| 60 | capacitor array |
| 61 | second capacitor arrangement |
| 62 | first node |
| 63 | second node |
| 64 | first capacitor |
| 65 | second capacitor |
| 66 | further transistor |
| 67 | first resistor |

| 68 | second resistor |
|---|---|
| 69 | further switch arrangement |
| 70 | third capacitor arrangement |
| 72 | third node |
| 73 | fourth node |
| 74 | third capacitor |
| 75 | fourth capacitor |
| 76 | additional transistor |
| 77 | third resistor |
| 78 | fourth resistor |
| 79 | additional switch arrangement |
| 80 | inverter |
| 90 | change-over switch |
| 91 | first inverter transistor |
| 92 | second inverter transistor |
| 93 | further change-over switch |
| 94 | third inverter transistor |
| 95 | fourth inverter transistor |
| 100 | oscillator arrangement |
| 101 | amplifier circuit |
| 102 | current source |
| 103 | first amplifier transistor |
| 104 | output |
| 105 | input |
| 106 | second amplifier transistor |
| 107 | further amplifier circuit |
| 108 | output |
| 109 | input |
| 110 | third amplifier transistor |
| 111 | current source node |
| 112 | fourth amplifier transistor |
| 113 | coil |
| 114 | varactor |
| 120 | first electrode |
| 121 | isolator |
| 122 | second electrode |
| 123 | electrode/isolating layer/electrode capacitor |
| 124 | fringing capacitor |
| 125 | thin-film resistor |
| 126 | diffused resistor |
| 130 | transistor |
| fosc | oscillator frequency |
| IB | bias current |
| IC | alternating current |
| IPH | further control signal |
| GND | reference potential |
| PH | control signal |
| VC | alternating voltage |
| VDD | supply voltage |
| VG | control voltage |
| VOS | oscillator output signal |
| VVC | varactor control signal |
| V1 | first voltage |
| V2 | second voltage |

**Claims**

1.  Capacitor array (60), comprising
    a capacitor arrangement (10) which comprises:

    - a capacitor (16),
    - a transistor (11) which is coupled in series to the capacitor (16) via a node (18),
    - a resistor (15),
    - a further capacitor (51) which is coupled in series to the transistor (11) via a further node (40),
    - a further resistor (41),
    and
    - a switch arrangement (42) having

        - a first terminal (17) for receiving a first voltage (V1), and
        - a second terminal (28) for receiving a second voltage (V2),

    **characterized in**
    **that** the switch arrangement (42) further having

        - a first switch (46) which couples the first terminal (17) of the switch arrangement (42) to an output (45) of the switch arrangement (42),
        - a second switch (47) which couples the second terminal (28) of the switch arrangement (42) to the output (45) of the switch arrangement (42),
        - a third switch (48) which couples the first terminal (17) of the switch arrangement (42) to a further output (50) of the switch arrangement (42),
        - a fourth switch (49) which couples the second terminal (28) of the switch arrangement (42) to the further output (50) of the switch arrangement (42),
        - the output (45) which is coupled via the resistor (15) to the node (18) between the capacitor (16) and the transistor (11) and
        - the further output (50) which is coupled via the further resistor (41) to the further node (40) between the further capacitor (51) and the transistor (11),

    wherein the switch arrangement (42) is designed such that the first voltage (V1) is applied to the output (45) and the further output (50) of the switch arrangement (42) during a first state of operation of the transistor (11) and the second voltage (V2) is applied to the output (45) and the further output (50) of the switch arrangement (42) during a second state of operation of the transistor (11),
    wherein the capacitor array (60) further comprises at least one further capacitor arrangement (61, 70), and
    wherein the capacitor array (60) is a binary weighted capacitor array and the quality factors of the capacitor arrangement (10) and of the at least one further capacitor arrangement (61, 70) are approximately equal.

2.  Capacitor array according to claim 1,
    the switch arrangement (42) comprising a control input (52) which is coupled to a control terminal (14) of the transistor (11).

3.  Capacitor array according to claim 1 or 2,
    wherein the first and the second switch (46, 47) are implemented together as a change-over switch (90).

4.  Capacitor array according to claim 3,
    wherein the change-over switch (90) comprises an inverter having

        - a control terminal which is coupled to a control input (52) of the switch arrangement (42),
        - an output which is coupled to the output (45) of the switch arrangement (42) and
        - a first and a second power supply terminal which are coupled to the first and the second terminal (17, 28) of the switch arrangement (42) respectively.

5.  Capacitor array according to one of claims 1 to 4, wherein the capacitor (16) is one of a group comprising an electrode/isolating layer/electrode capacitor (123) and a fringing capacitor (124).

**6.** Capacitor array according to one of claims 1 to 5, wherein the resistor (15) is one of a group comprising a thin film resistor (125), a diffused resistor (126) and a transistor (130) that is arranged as a resistor.

**7.** Capacitor array according to one of claims 1 to 6, wherein the third and the fourth switch (48, 49) are implemented together as a further change-over switch (93).

**8.** Capacitor array (60) according to one of claims 1 to 7, wherein the capacitor arrangement (10) is connected in parallel to the at least one further capacitor arrangement (61, 70) which comprises

- a first capacitor (64, 74),
- a further transistor (66, 76),
- a first resistor (67, 77) and
- a further switch arrangement (69, 79),

wherein the first capacitor (64, 74) and the further transistor (66, 76) are coupled together in series and the first resistor (67, 77) is arranged between the further switch arrangement (69, 79) and a first node (62, 72) between the first capacitor (64, 74) and the further transistor (66, 76).

**9.** Capacitor array (60) according to claim 8,
wherein the capacitance value of the first capacitor (64) is twice the capacitance value of the capacitor (16), the transistor (11) has a first width-to-length ratio W/L and the further transistor (66) has a second width-to-length ratio that is twice of the value of the first width-to-length ratio.

**10.** Amplifier arrangement, comprising the capacitor array (60) according to one of claims 1 to 9 and an amplifier circuit (101), wherein the capacitor array (60) couples an output (104) of the amplifier circuit (101) to an input (105) of the amplifier circuit (101).

**11.** Oscillator arrangement (100), comprising

- a first cross coupled pair of transistors (103, 110),
- a second cross coupled pair of transistors (106, 112) and
- the capacitor array (60) according to one of claims 1 to 9,

wherein the first cross coupled pair of transistors (103, 110), the second cross coupled pair of transistors (106, 112) and the capacitor array (60) are arranged in parallel between an input (105) and an output (104).

**12.** Method for switching an alternating current, comprising

- providing the alternating current (IC) to a series connection of a capacitor (16), a transistor (11) and a further capacitor (51),
- applying a control signal (PH) to a control terminal (14) of the transistor (11) such that the transistor (11) is in a first or a second state of operation as well as
- providing a first voltage (V1) to an output (45) of a switch arrangement (42) during the first state of operation of the transistor (11) and providing a second voltage (V2) to the output (45) of the switch arrangement (42) during the second state of operation of the transistor (11), wherein the output (45) of the switch arrangement (42) is coupled to a node (18) between the capacitor (16) and the transistor (11) via a resistor (15) and a further output (50) of the switch arrangement (42) is coupled via a further resistor (41) to a further node (40) between the further capacitor (51) and the transistor (11),

wherein a first switch (46) is arranged between a first terminal (17) of the switch arrangement (42) and the output (45), a second switch (47) is arranged between a second terminal (28) of the switch arrangement (42) and the output (45), a third switch (48) is arranged between the first terminal (17) of the switch arrangement (42) and the further output (50) and a fourth switch (49) is arranged between the second terminal (28) of the switch arrangement (42) and the further output (50),
wherein a capacitor array (60) is a binary weighted capacitor array and comprises

- a capacitor arrangement (10) which comprises the capacitor (16), the further capacitor (51), the transistor (11), the resistor (15), the further resistor (41) and the switch arrangement (42) and

- at least one further capacitor arrangement (61, 70), and wherein the quality factors of the capacitor arrangement (10) and of the at least one further capacitor arrangement/(61, 70) are approximately equal.

**Patentansprüche**

1.  Kondensatorarray (60), umfassend
    eine Kondensatoranordnung (10), die umfasst:

    - einen Kondensator (16),
    - einen Transistor (11), der über einen Knoten (18) in Reihe mit dem Kondensator (16) gekoppelt ist,
    - einen Widerstand (15),
    - einen weiteren Kondensator (51), der über einen weiteren Knoten (40) in Reihe mit dem Transistor (11) gekoppelt ist,
    - einen weiteren Widerstand (41)
    und
    - eine Schalteranordnung (42) mit

        - einem ersten Anschluss (17) zum Aufnehmen einer ersten Spannung (V1) und
        - einem zweiten Anschluss (28) zum Aufnehmen einer zweiten Spannung (V2),

    **dadurch gekennzeichnet,**
    **dass** die Schalteranordnung (42) darüber hinaus umfasst:

        - einen ersten Schalter (46), der den ersten Anschluss (17) der Schalteranordnung (42) mit einem Ausgang (45) der Schalteranordnung (42) koppelt,
        - einen zweiten Schalter (47), der den zweiten Anschluss (28) der Schalteranordnung (42) mit dem Ausgang (45) der Schalteranordnung (42) koppelt,
        - einen dritten Schalter (48), der den ersten Anschluss (17) der Schalteranordnung (42) mit einem weiteren Ausgang (50) der Schalteranordnung (42) koppelt,
        - einen vierten Schalter (49), der den zweiten Anschluss (28) der Schalteranordnung (42) mit dem weiteren Ausgang (50) der Schalteranordnung (42) koppelt,
        - den Ausgang (45), der über den Widerstand (15) mit dem Knoten (18) zwischen dem Kondensator (16) und dem Transistor (11) gekoppelt ist, und
        - den weiteren Ausgang (50), der über den weiteren Widerstand (41) mit dem weiteren Knoten (40) zwischen dem weiteren Kondensator (51) und dem Transistor (11) gekoppelt ist,

    wobei die Schalteranordnung (42) so ausgelegt ist, dass die erste Spannung (V1) während eines ersten Betriebszustands des Transistors (11) an den Ausgang (45) und den weiteren Ausgang (50) der Schalteranordnung (42) angelegt wird, und die zweite Spannung (V2) während eines zweiten Betriebszustands des Transistors (11) an den Ausgang (45) und den weiteren Ausgang (50) der Schalteranordnung (42) angelegt wird,
    wobei das Kondensatorarray (60) mindestens eine weitere Kondensatoranordnung (61, 70) umfasst und
    wobei es sich bei dem Kondensatorarray (60) um ein binär gewichtetes Kondensatorarray handelt und die Gütefaktoren der Kondensatoranordnung (10) und der mindestens einen weiteren Kondensatoranordnung (61, 70) in etwa gleich sind.

2.  Kondensatorarray nach Anspruch 1,
    wobei die Schalteranordnung (42) einen Steuereingang (52) umfasst, der mit einem Steueranschluss (14) des Transistors (11) gekoppelt ist.

3.  Kondensatorarray nach Anspruch 1 oder 2,
    wobei der erste und der zweite Schalter (46, 47) zusammen als ein Umschalter (90) ausgeführt sind.

4.  Kondensatorarray nach Anspruch 3,
    wobei der Umschalter (90) einen Inverter umfasst, der umfasst

        - einen Steueranschluss, der mit einem Steuereingang (52) der Schalteranordnung (42) gekoppelt ist,
        - einen Ausgang, der mit dem Ausgang (45) der Schalteranordnung (42) gekoppelt ist, und

- einen ersten und einen zweiten Energieversorgungsanschluss, die mit dem ersten beziehungsweise dem zweiten Anschluss (17, 28) der Schalteranordnung (42) gekoppelt sind.

5. Kondensatorarray nach einem der Ansprüche 1 bis 4,
wobei der Kondensator (16) ein Kondensator aus einer Gruppe ist, die einen Elektrode/Isolierschicht/Elektrode-Kondensator (123) und einen Streukondensator (124) umfasst.

6. Kondensatorarray nach einem der Ansprüche 1 bis 5,
wobei der Widerstand (15) ein Widerstand aus einer Gruppe ist, die einen Dünnschichtwiderstand (125), einen Diffusionswiderstand (136) und einen als Widerstand angeordneten Transistor (130) umfasst.

7. Kondensatorarray nach einem der Ansprüche 1 bis 6,
wobei der dritte und der vierte Schalter (48, 49) zusammen als ein weiterer Umschalter (93) ausgeführt sind.

8. Kondensatorarray (60) nach einem der Ansprüche 1 bis 7, wobei die Kondensatoranordnung (10) mit der mindestens einen weiteren Kondensatoranordnung (61, 70) parallelgeschaltet ist, die umfasst

- einen ersten Kondensator (64, 74),
- einen weiteren Transistor (66, 76),
- einen ersten Widerstand (67, 77) und
- eine weitere Schalteranordnung (69, 79),

wobei der erste Kondensator (64, 74) und der weitere Transistor (66, 76) miteinander in Reihe geschaltet sind und der erste Widerstand (67, 77) zwischen der weiteren Schalteranordnung (69, 79) und einem ersten Knoten (62, 72) zwischen dem ersten Kondensator (64, 74) und dem weiteren Transistor (66, 76) angeordnet ist.

9. Kondensatorarray (60) nach Anspruch 8,
wobei der Kapazitätswert des ersten Kondensators (64) den zweifachen Kapazitätswert des Kondensators (16) beträgt, der Transistor (11) ein erstes Breiten/Längen-Verhältnis W/L und der weitere Transistor (66) ein zweites Breiten/LängenVerhältnis hat, das das Zweifache des Werts des ersten Breiten/Längen-Verhältnisses beträgt.

10. Verstärkeranordnung, das Kondensatorarray (60) nach einem der Ansprüche 1 bis 9 und eine Verstärkerschaltung (101) umfassend, wobei das Kondensatorarray (60) einen Ausgang (104) der Verstärkerschaltung (101) mit einem Eingang (105) der Verstärkerschaltung (101) koppelt.

11. Oszillatoranordnung (100), umfassend

- ein erstes kreuzgekoppeltes Paar Transistoren (103, 110),
- ein zweites kreuzgekoppeltes Paar Transistoren (106, 112) und
- das Kondensatorarray (60) nach einem der Ansprüche 1 bis 9,

wobei das erste kreuzgekoppelte Paar Transistoren (103, 110), das zweite kreuzgekoppelte Paar Transistoren (106, 112) und das Kondensatorarray (60) zwischen einem Eingang (105) und einem Ausgang (104) parallelgeschaltet sind.

12. Verfahren zum Schalten eines Wechselstroms, umfassend

- Bereitstellen des Wechselstroms (IC) an eine Reihenschaltung aus einem Kondensator (16), einem Transistor (11) und einem weiteren Kondensator (51),
- Anlegen eines Steuersignals (PH) an einen Steueranschluss (14) des Transistors (11), und zwar so, dass sich der Transistor (11) in einem ersten oder einem zweiten Betriebszustand befindet, sowie
- Bereitstellen einer ersten Spannung (V1) an einen Ausgang (45) einer Schalteranordnung (42) während des ersten Betriebszustands des Transistors (11) und Bereitstellen einer zweiten Spannung (V2) an den Ausgang (45) der Schalteranordnung (42) während des zweiten Betriebszustands des Transistors (11),
wobei der Ausgang (45) der Schalteranordnung (42) über einen Widerstand (15) mit einem Knoten (18) zwischen dem Kondensator (16) und dem Transistor (11) gekoppelt ist und ein weiterer Ausgang (50) der Schalteranordnung (42) über einen weiteren Widerstand (41) mit einem weiteren Knoten (40) zwischen dem weiteren Kondensator (51) und dem Transistor (11) gekoppelt ist,

wobei ein erster Schalter (46) zwischen einem ersten Anschluss (17) der Schalteranordnung (42) und dem Ausgang (45) angeordnet ist, ein zweiter Schalter (47) zwischen einem zweiten Anschluss (28) der Schalteranordnung (42) und dem Ausgang (45) angeordnet ist, ein dritter Schalter (48) zwischen dem ersten Anschluss (17) der Schalteranordnung (42) und dem weiteren Ausgang (50) angeordnet ist und ein vierter Schalter (49) zwischen dem zweiten Anschluss (28) der Schalteranordnung (42) und dem weiteren Ausgang (50) angeordnet ist, wobei ein Kondensatorarray (60) ein binär gewichtetes Kondensatorarray ist und umfasst

- eine Kondensatoranordnung (10), die den Kondensator (16), den weiteren Kondensator (51), den Transistor (11), den Widerstand (15), den weiteren Widerstand (41) und die Schalteranordnung (42) umfasst, und
- mindestens eine weitere Kondensatoranordnung (61, 70), und

wobei die Gütefaktoren der Kondensatoranordnung (10) und der mindestens einen weiteren Kondensatoranordnung (61, 70) in etwa gleich sind.

**Revendications**

1. Réseau de condensateurs (60), comprenant

- un agencement de condensateurs (10) qui comprend:

- un condensateur (16),
- un transistor (11) qui est couplé en série au condensateur (16) via un noeud (18),
- une résistance (15),
- un condensateur supplémentaire (51) qui est couplé en série au transistor (11) via un noeud supplémentaire (40),
- une résistance supplémentaire (41),
et
- un agencement d'interrupteurs (42) présentant

- une première borne (17) destinée à recevoir une première tension (V1), et
- une deuxième borne (28) destinée à recevoir une deuxième tension (V2),

**caractérisé en ce que** l'agencement d'interrupteurs (42) présente en outre

- un premier interrupteur (46) qui couple la première borne (17) de l'agencement d'interrupteurs (42) à une sortie (45) de l'agencement d'interrupteurs (42),
- un deuxième interrupteur (47) qui couple la deuxième borne (28) de l'agencement d'interrupteurs (42) à la sortie (45) de l'agencement d'interrupteurs (42),
- un troisième interrupteur (48) qui couple la première borne (17) de l'agencement d'interrupteurs (42) à une sortie supplémentaire (50) de l'agencement d'interrupteurs (42),
- un quatrième interrupteur (49) qui couple la deuxième borne (28) de l'agencement d'interrupteurs (42) à la sortie supplémentaire (50) de l'agencement d'interrupteurs (42),
- la sortie (45) qui est couplée via la résistance (15) au noeud (18) entre le condensateur (16) et le transistor (11) et
- la sortie supplémentaire (50) qui est couplée via la résistance supplémentaire (41) au noeud supplémentaire (40) entre le condensateur supplémentaire (51) et le transistor (11),

dans lequel l'agencement d'interrupteurs (42) est conçu de telle sorte que la première tension (V1) soit appliquée à la sortie (45) et la sortie supplémentaire (50) de l'agencement d'interrupteurs (42) pendant un premier état de fonctionnement du transistor (11) et la deuxième tension (V2) soit appliquée à la sortie (45) et la sortie supplémentaire (50) de l'agencement d'interrupteurs (42) pendant un deuxième état de fonctionnement du transistor (11), dans lequel le réseau de condensateurs (60) comprend en outre au moins un agencement de condensateurs supplémentaire (61, 70), et dans lequel le réseau de condensateurs (60) est un réseau de condensateurs pondéré binaire et les facteurs de qualité de l'agencement de condensateurs (10) et de l'au moins un agencement de condensateurs supplémentaire (61, 70) sont approximativement égaux.

2. Réseau de condensateurs selon la revendication 1, l'agencement d'interrupteurs (42) comprenant une entrée de commande (52) qui est couplée à une borne de commande (14) du transistor (11).

3. Réseau de condensateurs selon la revendication 1 ou 2, dans lequel le premier et le deuxième interrupteur (46, 47) sont implémentés ensemble comme interrupteur à permutation (90).

4. Réseau de condensateurs selon la revendication 3,
dans lequel l'interrupteur à permutation (90) comprend un inverseur présentant

- une borne de commande qui est couplée à une entrée de commande (52) de l'agencement d'interrupteurs (42),
- une sortie qui est couplée à la sortie (45) de l'agencement d'interrupteurs (42) et
- une première et une deuxième borne d'alimentation électrique qui sont couplées à la première et la deuxième borne (17, 28) de l'agencement d'interrupteurs (42), respectivement.

5. Réseau de condensateurs selon l'une des revendications 1 à 4,
dans lequel le condensateur (16) est l'un d'un groupe comprenant un condensateur à électrode/couche isolante/électrode (123) et un condensateur à effet de bord (124).

6. Réseau de condensateurs selon l'une des revendications 1 à 5,
dans lequel la résistance (15) est l'un d'un groupe comprenant une résistance à couche mince (125), une résistance diffusée (126) et un transistor (130) qui est agencé comme résistance.

7. Réseau de condensateurs selon l'une des revendications 1 à 6,
dans lequel le troisième et le quatrième interrupteur (48, 49) sont implémentés ensemble comme interrupteur à permutation supplémentaire (93).

8. Réseau de condensateurs (60) selon l'une des revendications 1 à 7,
dans lequel l'agencement de condensateurs (10) est connecté en parallèle à l'au moins un agencement de condensateurs supplémentaire (61, 70) qui comprend

- un premier condensateur (64, 74),
- un transistor supplémentaire (66, 76),
- une première résistance (67, 77) et
- un agencement d'interrupteurs supplémentaire (69, 79),

dans lequel le premier condensateur (64, 74) et le transistor supplémentaire (66, 76) sont couplés ensemble en série et la première résistance (67, 77) est agencée entre l'agencement d'interrupteurs supplémentaire (69, 79) et un premier noeud (62, 72) entre le premier condensateur (64, 74) et le transistor supplémentaire (66, 76).

9. Réseau de condensateurs (60) selon la revendication 8, dans lequel la valeur de capacité du premier condensateur (64) est le double de la valeur de capacité du condensateur (16), le transistor (11) a un premier rapport largeur/longueur (W/L) et le transistor supplémentaire (66) a un deuxième rapport largeur/longueur qui est le double de la valeur du premier rapport largeur/longueur.

10. Agencement d'amplificateur, comprenant le réseau de condensateurs (60) selon l'une des revendications 1 à 9 et un circuit amplificateur (101), dans lequel le réseau de condensateurs (60) couple une sortie (104) du circuit amplificateur (101) à une entrée (105) du circuit amplificateur (101).

11. Agencement d'oscillateur (100), comprenant

- une première paire à couplage transversal de transistors (103, 110),
- une deuxième paire à couplage transversal de transistors (106, 112) et
- le réseau de condensateurs (60) selon l'une des revendications 1 à 9,

dans lequel la première paire à couplage transversal de transistors (103, 110), la deuxième paire à couplage transversal de transistors (106, 112) et le réseau de condensateurs (60) sont agencés en parallèle entre une entrée (105) et une sortie (104).

12. Procédé de commutation d'un courant alternatif, comprenant

- la fourniture du courant alternatif (IC) à une connexion en série d'un condensateur (16), d'un transistor (11) et d'un condensateur supplémentaire (51),
- l'application d'un signal de commande (PH) à une borne de commande (14) du transistor (11) de telle sorte que le transistor (11) soit dans un premier ou un deuxième état de fonctionnement ainsi que
- la fourniture d'une première tension (V1) à une sortie (45) d'un agencement d'interrupteurs (42) pendant le premier état de fonctionnement du transistor (11) et la fourniture d'une deuxième tension (V2) à la sortie (45) de l'agencement d'interrupteurs (42) pendant le deuxième état de fonctionnement du transistor (11), dans lequel la sortie (45) de l'agencement d'interrupteurs (45) est couplée à un noeud (18) entre le condensateur (16) et le transistor (11) via une résistance (15) et une sortie supplémentaire (50) de l'agencement d'interrupteurs (42) est couplée via une résistance supplémentaire (41) à un noeud supplémentaire (40) entre le condensateur supplémentaire (51) et le transistor (11),

dans lequel un premier interrupteur (46) est agencé entre une première borne (17) de l'agencement d'interrupteurs (42) et la sortie (45), un deuxième interrupteur (47) est agencé entre une deuxième borne (28) de l'agencement d'interrupteurs (42) et la sortie (45), un troisième interrupteur (48) est agencé entre la première borne (17) de l'agencement d'interrupteurs (42) et la sortie supplémentaire (50) et un quatrième interrupteur (49) est agencé entre la deuxième borne (28) de l'agencement d'interrupteurs (42) et la sortie supplémentaire (50),
dans lequel un réseau de condensateurs (60) est un réseau de condensateurs pondéré binaire et comprend

- un agencement de condensateurs (10) qui comprend le condensateur (16), le condensateur supplémentaire (51), le transistor (11), la résistance (15), la résistance supplémentaire (41) et l'agencement d'interrupteurs (42) et
- au moins un agencement de condensateurs supplémentaire (61, 70), et

dans lequel les facteurs de qualité de l'agencement de condensateurs (10) et de l'au moins un agencement de condensateurs supplémentaire (61, 70) sont approximativement égaux.

## FIG 1A

## FIG 1B

## FIG 1C

# FIG 2A

# FIG 2B

## FIG 3A

## FIG 3B

## FIG 4

## FIG 5

## FIG 6A

FIG 6B

FIG 7A

FIG 7B

FIG 7C

**EP 2 471 179 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20070247237 A1
- US 20050012565 A1